# EUROPEAN PATENT APPLICATION

(11) **EP 4 044 230 A1**
(43) Date of publication of application: **17.08.2022**
(21) Application number: 20876915.8
(22) Date of filing: 31.08.2020
(51) Int. Cl.: H01L 25/16, H01L 33/38, H01L 33/50, H01L 33/58, H01L 33/60, H01L 51/52

(54) **FULL-COLOR µLED DISPLAY DEVICE ELIMINATING ELECTRICAL CONTACT AND MASS TRANSFER**

(30) Priority: 16.10.2019 CN 201910982161
(71) Applicant: Fu Zhou University, Fuzhou, Fujian 350108 (CN); Mindu Innovation Lab, Fuzhou, Fujian 350108 (CN)
(72) Inventor: GUO, Tailiang, Fuzhou, Fujian 350108 (CN); LIU, Penghui, Fuzhou, Fujian 350108 (CN); ZHANG, Yongai, Fuzhou, Fujian 350108 (CN); ZHOU, Xiongtu, Fuzhou, Fujian 350108 (CN); WU, Chaoxing, Fuzhou, Fujian 350108 (CN); LIN, Zhixian, Fuzhou, Fujian 350108 (CN); SUN, Lei, Fuzhou, Fujian 350108 (CN); YAN, Qun, Fuzhou, Fujian 350108 (CN)
(74) Representative: Bayramoglu et al.
(86) International application number: PCT/CN2020/112397
(87) International publication number: WO 2021/073285

(57) **Abstract**

The present invention relates to a full-color µLED display device without electrical contact and mass transfer. The full-color µLED display device without electrical contact and mass transfer comprises a lower driving electrode disposed on a surface of a lower transparent substrate, optical micro-structures disposed on an upper surface and a lower surface of an upper transparent substrate, an upper driving electrode, a barrier micro-structure connecting the upper transparent substrate and the lower transparent substrate, a µLED crystal grain disposed in the barrier micro-structure, wavelength down-conversion light emitting layers, an insulating layer and a control module, wherein a unit R for displaying red light, a unit G for displaying green light and a unit B for displaying blue light are successively formed on the barrier micro-structure along a direction of the upper driving electrode. The upper driving electrode and the lower driving electrode are free from electrical contact with the µLED crystal grain. The control module provides an alternating driving signal and electrical coupling to lighten the µLED crystal grain so as to excite the wavelength down-conversion light emitting layers to realize full color display, so that there are no complicated manufacturing process for a three-primary-color µLED chip in a full color µLED device and complicated Bonding and mass transfer processes of a light emitting chip and a driving chip, the manufacturing period of µLED display is shortened, and the manufacturing cost is lowered.

## Description

### 1. Technical Field

The present invention relates to the field of integrated semiconductor display, particularly to a full-color µLED display device without electrical contact and mass transfer.

### 2. Description of Related Art

In the technical field of panel display, micron order µLED display (µLED display for short) refers to miniaturizing a conventional LED to form a micron order LED array so as to achieve an ultra-high density pixel resolution. Compared with OLED and LCD display, µLED with self-illumination features low power consumption, high brightness, ultrahigh definition, high color saturation, higher response speed, longer service life, higher working efficiency and the like. In addition, µLED display is a unique device integrating driving, light emitting and signal transmission with high light emitting efficiency and low power consumption and is a display device realizing an ultrahigh-scale integrated light emitting unit. Due to characteristics of high density, small size and ultra-high pixel, µLED display will become a leader of the third generation display technology mainly featuring high fidelity, interaction and individual display. By integrating two technical characteristics of LCD and LED, the product performance is far better than that of current TFT-LCD and OLED, and it can be widely applied in the fields of flexible display, vehicle-mounted display, transparent display, large area display, wear display, AR/VR and the like. However, as a result of problems in size and quantity and the like, there are still a series of technical difficulties in the aspects of bonding, transferring, driving, colorizing and the like in integration of micron order LED.

At present, full color µLED display generally refers to performing epitaxial growth on a GaN or GaAs substrate by means of metal organic chemical vapor deposition (MOCVD), preparing a three-primary-color: red, green and blue µLED chip via multiple processes and bonding the three-primary-color µLED chip and a driving chip on a circuit board by means of chip transferring and bonding processes to form full color three-primary-color display pixels. In this technology it is needed to realize precise electrical contact between the driving electrode and the driving module in the µLED chip by means of precise aligning and bonding and pickup, place and assemble massive µLED crystal grains. In the colorized technical field, it can further be realized by means of a color conversion method, an optical prism synthesis method and a method of emitting light with different wavelengths by controlling the structure and size of the LED and the like. Color conversion of blue light LED and red and green quantum dots is the mainstream technical route to realize full color µLED display. In the prior art, it is a common technical optimized means to realize Micro-LED full color display by means of a quantum dot technology. Furthermore, there are many process technologies and preparation schemes at present. In Chinese patents CN106356386A, CN108257949A and CN109256455A, the blue µLED chip is filled with red quantum dot and green quantum dots to realize full color display. It is needed to manufacture a cathode and an anode for the blue µLED chip and pattern the quantum dots as well. Meanwhile, the µLED chip is subjected to bonding with the driving electrode chip after mass transfer, and the electrodes are contacted to drive the blue µLED chip to emit light so as to realize full color display, which results in a prolonged manufacturing period and a higher manufacturing cost of the µLED device.

In conclusion, the prevent invention provides a full-color µLED display device without electrical contact and mass transfer. According to the µLED device, electron-hole recombination is completed by a homogeneous pn junction nanometer material to generate radiative transition as well. Different from a driving mode of a conventional µLED, an n-type semiconductor layer and a p-type semiconductor layer of the µLED crystal grain are free from direct electrical contact with an external driving electrode. In addition, the light emitting brightness of the full-color µLED display device without electrical contact and mass transfer provided by the present invention is dependent on a voltage frequency. The control module provides the alternating driving signal to lighten the µLED crystal grain by means of electrical coupling so as to excite the RGB wavelength down-conversion light emitting layers on the surface of the µLED crystal grain to complete color conversion, thereby achieving full color µLED display. According to the present invention, there are no complicated manufacturing process of the three-primary-color chip, process of complicated bonding of the light emitting chip and the driving chip and mass transfer process of the µLED chip, the manufacturing period of the µLED device is effectively shortened and the manufacturing cost of the µLED device is effectively lowered, and it is expected to improve the market competitiveness of full color µLED display greatly.

### BRIEF SUMMARY OF THE INVENTION

The present invention is intended to overcome shortcomings in the prior art and provide a full-color µLED display device without electrical contact and mass transfer. The driving electrode of the device is free from direct electrical contact with the n-type semiconductor layer and the p-type semiconductor layer of the µLED crystal grain. The control module is electrically connected with the upper driving electrode and the lower driving electrode respectively to provide alternating driving signals to the upper driving electrode and the lower driving electrode and form a driving electric field between the upper driving electrode and the lower driving electrode, and the driving electric field controls the electron-hole recombination of the µLED crystal grain and emits the first light source which emits RGB rays via the wavelength down-conversion light emitting layers in the unit R, the unit G and the unit B to realize full color display via controllable scanning. According to the full-color µLED display device without electrical contact and mass transfer provided by the present invention, there are no complicated manufacturing process of the red/green/blue three-primary-color µLED chip, process of complicated bonding of the µLED light emitting chip and the driving chip and mass transfer process of the µLED chip as well, so that the manufacturing period of the µLED is effectively shortened and the manufacturing cost of the µLED display is effectively lowered, and it is expected to improve the market competitiveness of full color µLED display greatly.

In order to achieve the above-mentioned objective, a technical scheme of the present invention is as follows: a full-color µLED display device without electrical contact and mass transfer includes a lower transparent substrate, an upper lower transparent substrate, a µLED crystal grain, wavelength down-conversion light emitting layers, an insulating layer, optical micro-structures, a control module, a lower driving electrode disposed on a surface of the lower transparent substrate, an upper driving electrode disposed on a surface of the upper transparent substrate, a barrier micro-structure connecting the upper transparent substrate and the lower transparent substrate, wherein the barrier micro-structure comprises a unit R for displaying red light, a unit G for displaying green light and a unit B for displaying blue light successively formed along a direction of the upper driving electrode, wherein the barrier micro-structure in the unit R is internally provided with a red wavelength down-conversion light emitting layer and a µLED crystal grain, the barrier micro-structure in the unit G is internally provided with a green wavelength down-conversion light emitting layer and a µLED crystal grain, and the barrier micro-structure in the unit B is internally provided with a blue light µLED crystal grain or a blue wavelength down-conversion light emitting layer and a µLED crystal grain; and the upper driving electrode and the lower driving electrode are free from direct electrical contact with the µLED crystal grains; the control module is electrically connected with the upper driving electrode and the lower driving electrode respectively, provides alternating driving signals to the upper driving electrode and the lower driving electrode and forms a driving electric field between the upper driving electrode and the lower driving electrode, the driving electric field controls electron-hole recombinations of the µLED crystal grains and emits a first light that emits RGB rays via the wavelength down-conversion light emitting layers in the unit R, the unit G and the unit B so as to realize full color display via controllable scanning.

In an embodiment of the present invention, the µLED crystal grain is either a blue light µLED crystal grain or a µLED crystal grain capable of emitting light with wavelength shorter than that of blue light; the µLED crystal grain is formed by connecting several µLED chips in series along a perpendicular direction or is formed by connecting the several µLED chips in parallel along a horizontal direction or is formed by stacking the several µLED chips arbitrarily; a horizontal size of the µLED crystal grain ranges from 1 nm to 1000 µm, a longitudinal size of the µLED crystal grain ranges from 1 nm to 1000 µm, and a thickness thereof ranges from 1 nm to 100 µm.

In an embodiment of the present invention, the µLED chip includes a p-type semiconductor material, a light emitting structure and an n-type semiconductor material, the p-type semiconductor material, the light emitting structure and the n-type semiconductor material being stacked along a perpendicular direction to form a semiconductor junction; the semiconductor junction includes one of or more of a combination of a single semiconductor junction, a semiconductor junction pair and a multi-semiconductor junction; a thickness of the p-type semiconductor material ranges from 1 nm to 2.0 µm, a thickness of the light emitting structure ranges from 1 nm to 1.0µm, and a thickness of the n-type semiconductor material ranges from 1 nm to 2.5 µm.

In an embodiment of the present invention, the upper driving electrode is composed of several line electrodes that are parallel one another and is disposed on the surface of the upper transparent substrate along the horizontal direction of the µLED crystal grain; the lower driving electrode is composed of several line electrodes that are parallel one another and is disposed on the surface of the upper transparent substrate along the perpendicular direction of the µLED crystal grain; and the upper electrode and the lower electrode are perpendicular to each other, and an independent space can be formed in a gap between the upper electrode and the lower electrode.

In an embodiment of the present invention, at least one of the upper driving electrode and the lower driving electrode is a transparent electrode, and a material of the transparent electrode includes graphene, indium tin oxide, a carbon nano tube, a silver nanowire and a copper nanowire and a combination thereof; and a material of the other transparent electrode includes gold, silver, aluminum and copper or an alloy or a laminated structure thereof.

In an embodiment of the present invention, each of the wavelength down-conversion light emitting layers irradiated by rays emitted by the µLED crystal grain excites a ray with a longer wavelength, the wavelength down-conversion light emitting layer is a quantum dot material or a phosphor material or a mixed material of quantum dots and phosphors; the wavelength down-conversion light emitting layer comprises R/G/B quantum dots or R/G/B phosphors, the wavelength down-conversion light emitting layers are respectively disposed in the unit R, the unit G and the unit B, and a thickness of the wavelength down-conversion light emitting layer ranges from 1 nm to 10 µm; the wavelength down-conversion light emitting layers can be disposed on the surfaces of the upper driving electrode and the lower driving electrode or can be disposed on the outer surfaces of the µLED crystal grains, or can be mixed and coated together with the µLED crystal grains and are disposed in the independent space formed by the upper driving electrode and the lower driving electrode.

In an embodiment of the present invention, each of the barrier micro-structures is perpendicularly disposed on the surface of the upper transparent substrate or is disposed on the surface of the lower transparent substrate, and forms an independent closed space with the upper driving electrode, the lower driving electrode, the wavelength down-conversion light emitting layer and the µLED crystal grain.

In an embodiment of the present invention, the insulators can be disposed on the surfaces of the upper driving electrode and the lower driving electrode or can be disposed on the surfaces of the wavelength down-conversion light emitting layers or can be disposed between the wavelength down-conversion light emitting layer and the upper driving electrode and between the wavelength down-conversion light emitting layer and the lower driving electrode; a material of the insulators is an organic insulating material, an inorganic insulating material or a combination thereof; and a thickness of the insulating material ranges from 1 nm to 10 µm.

In an embodiment of the present invention, the control module can provide an alternating voltage with time-varying amplitude and polarity, a waveform of the alternating voltage comprising a sine wave, a triangular wave, a square wave, a pulse or a composite wave, and a frequency of the alternating voltage ranging from 1 Hz to 1000 MHz.

In an embodiment of the present invention, each of the optical micro-structures is composed of a distributed Bragg reflecting layer and a convex lens and is located on the other surface of the substrate of the transparent electrode, the optical micro-structures being in one-to-one-correspondence to the unit R, the unit G and the unit B; the distributed Bragg reflecting layer is formed by stacking two thin films with a high refractive index and a low refractive index, and red light, green light and blue light in the units are transmitted respectively by controlling a stacking pair number of the distributed Bragg reflecting layers in the unit R, the unit G and the unit B and a thickness of the thin films, and unabsorbed rays emitted by the µLED are reflected back to the barrier micro-structures via the distributed Bragg reflecting layer to excite the wavelength down-conversion light emitting layers again so as to enhance the emergent intensity, so that the light emitting efficiency of the display device is improved; the convex lens is a transparent convex lens, a horizontal size of the convex lens is greater than or equal to a horizontal size of the µLED crystal grain but smaller than or equal to a horizontal size of the corresponding unit R or G or B; and a longitudinal size of the convex lens is greater than or equal to a longitudinal size of the µLED crystal grain but smaller than or equal to a longitudinal size of the corresponding unit R or G or B.

Compared with the prior art, the present invention has the following beneficial effects:
(1) As an external electrode in the µLED display device provided by the present invention is free from electrical contact with a p-type semiconductor layer and an n-type semiconductor layer in the µLED crystal grain, there are no complicated manufacturing process of a µLED chip and complicated bonding and mass transfer processes of the µLED light emitting chip and a driving chip, so that the production cycle of the µLED light emitting device is shortened, and the manufacturing cost of the µLED display is reduced.
(2) The control module provided by the present invention is electrically connected with the upper driving electrode and the lower driving electrode respectively to provide alternating driving signals to the upper driving electrode and the lower driving electrode and form a driving electric field between the upper driving electrode and the lower driving electrode, and in the driving mode, the light emitting brightness of the µLED light emitting device without electrical contact can be regulated and controlled effectively by regulating the driving voltage and the working frequency.
(3) The alternating driving electric field provided by the present invention controls electron-hole recombination of the µLED crystal grain and sends the first light source that emits RGB rays via the wavelength down-conversion light emitting layers in the unit R, the unit G and the unit B to realize color conversion; meanwhile, in combination with the optical micro-structure composed of the distributed Bragg reflecting layer and the convex lens, the color conversion efficiency of the µLED device without electrical contact is improved effectively, which is of important significance in developing and applying the full color µLED display.

### BRIEF DESCRIPTION OF THE SEVERAL VIEWS OF THE DRAWINGS

FIG. 1 is a structural schematic diagram of a full-color µLED display device without electrical contact and mass transfer of a first embodiment of the present invention.
FIG. 2 is a structural schematic diagram of an arbitrarily disposed µLED of a first embodiment of the present invention.
FIG. 3 is a working principle diagram of a full-color µLED display device without electrical contact and mass transfer in a unit R of a first embodiment of the present invention.
FIG. 4 is a working principle diagram of a full-color µLED display device without electrical contact and mass transfer in a unit G of a first embodiment of the present invention.
FIG. 5 is a working principle diagram of a full-color µLED display device without electrical contact and mass transfer in a unit B of a first embodiment of the present invention.
FIG. 6 is a display principle diagram of a full-color µLED display device without electrical contact and mass transfer of a first embodiment of the present invention.

In the drawings, 11-unit R; 12-unit G; 13-unit B; 100, 200-transparent substrate; 101-lower driving electrode; 201-upper driving electrode; 102 and 202-insulator; 310-µLED chip; 300-µLED crystal grain; 301-n-type semiconductor material; 302-p-type semiconductor material; 303-light emitting structure; 401-red wavelength down-conversion light emitting layer; 402-green wavelength down-conversion light emitting layer; 403-blue wavelength down-conversion light emitting layer; 500-optical micro-structure; 501 and 503-distributed Bragg reflecting layer; 502-convex lens; 600-control module; 111-red light; 112-green light; 113-first light source.

### DETAILED DESCRIPTION OF THE INVENTION

In order to make purposes, technical schemes and advantages of the present invention clearer, the present invention is further described in detail below in combination with specific embodiments and related drawings. In the drawings, for the purpose of clarity, thicknesses of the layers and areas are increased. As the schematic diagrams, they are not construed to strictly reflect the proportional relation of geometric dimensions. Reference diagrams herein are schematic diagrams of idealized embodiments of the present invention. The embodiments of the present invention shall not be construed as limitation to specific shapes in the regions shown in the drawings and shall include obtained shapes, for example, deviations caused by manufacturing. In the embodiments, they are represented by rectangles or circles. Representations in the drawings are schematic and shall not be construed as limitation to the scope of the present invention. The size of a fluctuating pattern and a fluctuating period of a barrier in the embodiment are within a certain range and can be designed according to an actual requirement. A numerical value of the fluctuating period in the embodiment is only schematic and shall not be construed as limitation to the scope of the present invention. It is to be noted that the terms used herein are merely to describe specific implementation modes rather than being intended to limit the exemplary implementation modes according to the application. As used herein, unless otherwise specified in the context, the singular form is further intended to include plural form. In addition, it is to be further understood that when the terms "comprise" and/or "include" are used in the description, it indicates that there are features, steps, operations, apparatuses, assemblies and/or their combinations.

A full-color µLED display device without electrical contact and mass transfer provided by the present invention includes: a lower transparent substrate, an upper lower transparent substrate, a µLED crystal grain, wavelength down-conversion light emitting layers, an insulating layer, optical micro-structures, a control module, a lower driving electrode disposed on a surface of the lower transparent substrate, an upper driving electrode disposed on a surface of the upper transparent substrate, a barrier micro-structure connecting the upper transparent substrate and the lower transparent substrate, wherein the barrier micro-structure includes a unit R for displaying red light, a unit G for displaying green light and a unit B for displaying blue light successively formed along a direction of the upper driving electrode, wherein the barrier micro-structure in the unit R is internally provided with a red wavelength down-conversion light emitting layer and a µLED crystal grain, the barrier micro-structure in the unit G is internally provided with a green wavelength down-conversion light emitting layer and a µLED crystal grain, and the barrier micro-structure in the unit B is internally provided with a blue light µLED crystal grain or a blue wavelength down-conversion light emitting layer and a µLED crystal grain; and the upper driving electrode and the lower driving electrode are free from direct electrical contact with the µLED crystal grains; the control module is electrically connected with the upper driving electrode and the lower driving electrode respectively, provides alternating driving signals to the upper driving electrode and the lower driving electrode and forms a driving electric field between the upper driving electrode and the lower driving electrode, the driving electric field controls electron-hole recombinations of the µLED crystal grains and emits a first light that emits RGB rays via the wavelength down-conversion light emitting layers in the unit R, the unit G and the unit B so as to realize full color display via controllable scanning.

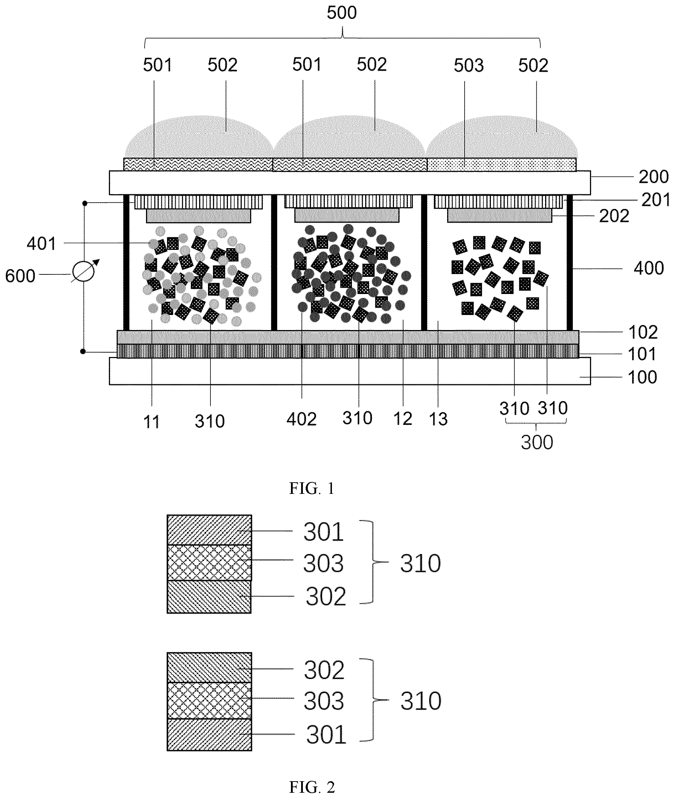

As shown in FIG. 1, the first embodiment of the present invention provides a full-color µLED display device without electrical contact and mass transfer, including: a lower transparent substrate 100, an upper lower transparent substrate 200, a µLED crystal grain 300, wavelength down-conversion light emitting layers 401 and 402, insulating layers 102 and 202, an optical micro-structure 500, a control module 600, a lower driving electrode 101 disposed on a surface of the lower transparent substrate 100, an upper driving electrode 201 disposed on a surface of the upper transparent substrate 200 and a barrier micro-structure 400 connecting the upper transparent substrate 100 and the lower transparent substrate 200. The barrier micro-structure 400 includes a unit R 11 for displaying red light, a unit G 12 for displaying green light and a unit B 13 for displaying blue light successively formed along a direction of the upper driving electrode 201, wherein the barrier micro-structure in the unit R 11 is internally provided with a red wavelength down-conversion light emitting layer 401 and a µLED crystal grain 300, the barrier micro-structure in the unit G 12 is internally provided with a green wavelength down-conversion light emitting layer 402 and a µLED crystal grain 300, and the barrier micro-structure in the unit B 13 is internally provided with a blue light µLED crystal grain 300 or a blue wavelength down-conversion light emitting layer 403 and a µLED crystal grain 300. The upper driving electrode 201 and the lower driving electrode 101 are free from direct electrical contact with the µLED crystal grain 300, the control module 600 is electrically connected with the upper driving electrode 201 and the lower driving electrode 101 respectively, provides alternating driving signals to the upper driving electrode 201 and the lower driving electrode 101 and form a driving electric field between the upper driving electrode 201 and the lower driving electrode 101, and the driving electric field controls an electron-hole recombination of the µLED crystal grain 300 and emits a first light source 111 that emits RGB rays via the wavelength down-conversion light emitting layers 401, 402 and 403 in the unit R 11, the unit G 12 and the unit B 13 so as to realize full color display by controllable scanning.

In the embodiment, the µLED crystal grain is either the blue light µLED crystal grain or the µLED crystal grain capable of emitting wavelengths, such as ultraviolet wavelength, shorter than that of the blue light, the µLED crystal grain 300 is formed by connecting several µLED chips 310 in series along a perpendicular direction or by connecting several µLED chips 310 in parallel along a horizontal direction or by stacking several µLED chips 310 arbitrarily; a horizontal size of the µLED crystal grain 300 ranges from 1 nm to 1000 µm, a longitudinal size of the µLED crystal grain 300 ranges from 1 nm to 1000 µm, and a thickness thereof ranges from 1 nm to 100 µm; the µLED chip 310 includes a p-type semiconductor material 302, a light emitting structure 303 and an n-type semiconductor material 301 (the p-type semiconductor material, the light emitting structure 303 and the n-type semiconductor material can be an organic material, an inorganic material or a high molecular material), the p-type semiconductor material 302, the light emitting structure 303 and the n-type semiconductor material 301 being stacked along a perpendicular direction to form a semiconductor junction, namely, the µLED chip 310; the semiconductor structure can include, but not limited to, a single semiconductor junction (p-light emitting structure-n), a semiconductor pair junction (p-light emitting structure-n-light emitting structure-p junction or n-light emitting structure-p-light emitting structure-n junction) and a plurality of semiconductor junctions and combinations thereof. A thickness of the p-type semiconductor material 302 ranges from 1 nm to 2.0 µm, a thickness of the light emitting structure 303 ranges from 1 nm to 1.0 µm, and a thickness of the n-type semiconductor material 301 ranges from 0.1 nm to 2.5 µm.The µLED crystal grain 300 is preferably formed by arbitrarily stacking the several blue light µLED chips 310 in the embodiment. The thickness of the p-type semiconductor material 302 is 0.3 µm, the thickness of the light emitting structure 303 is 0.1 µm, and the thickness of the n-type semiconductor material 301 is 0.8 µm. The horizontal size of the blue light µLED crystal grain 300 is 1.0 µm, and the longitudinal size of the blue light µLED crystal grain 300 is 1.0 µm.

In the embodiment, the upper driving electrode 201 is composed of several parallel line electrodes and is disposed on a surface of the upper transparent substrate 200 along a horizontal direction of the µLED crystal grain 300, and the lower driving electrode 101 is composed of several parallel line electrodes and is disposed on a surface of the lower transparent substrate 100 along a perpendicular direction of the µLED crystal grain 300; the upper driving electrode 201 and the lower driving electrode 101 are perpendicular to each other, and there is a certain gap therebetween to form an independent space; at least one of the upper driving electrode 201 and the lower driving electrode 101 is a transparent electrode, and a material of the transparent electrode can include, but not limited to, graphene, indium tin oxide, a carbon nano tube, a silver nanowire and a copper nanowire and a combination thereof, and a material of the other transparent electrode can include, but not limited to, gold, silver, aluminum and copper or an alloy or a laminated structure thereof. In the embodiment, the upper driving electrode 201 is preferably a transparent electrode and a material of the electrode is indium tin oxide, and the lower driving electrode 101 is a metal aluminum electrode.

In the embodiment, the wavelength down-conversion light emitting layers 401, 402 and 403 irradiated by the µLED crystal grain 300 excites the rays with a longer wavelength, and the wavelength down-conversion light emitting layers 401, 402 and 403 are quantum dot materials or phosphor materials or a mixed material of the quantum dot materials and the phosphor materials; the wavelength down-conversion light emitting layers 401, 402 and 403 can be disposed on the surfaces of the upper driving electrode 201 and the lower driving electrode 101 or can be disposed on an outer surface of the µLED crystal grain 300 or can be mixed and coated together with the µLED crystal grain 300, and is disposed in the independent space formed by the upper driving electrode 201 and the lower driving electrode 101; and the wavelength down-conversion light emitting layers 401, 402 and 403 include red, green and blue quantum dot light emitting layers, can be red, green and blue phosphor emitting layers and are respectively disposed in the unit R 11, the unit G 12 and the unit B 13, and a thickness of each of the wavelength down-conversion light emitting layers ranges from 1 nm to 5 µm. In the embodiment, the blue light µLED crystal grain 300 is mixed and coated with the quantum dot 401 and the green quantum dot 402 preferably, a thickness of the quantum dot light emitting layer being 2.5 µm.

In an embodiment, the barrier micro-structures 400 are in one-to-one-correspondence to the unit R 11, the unit G 12 and the unit B 13, are perpendicularly disposed on the surfaces of the upper transparent substrate 200 and the lower transparent substrate 100, and form independent closed spaces with the upper driving electrode 201, the lower driving electrode 101, the wavelength down-conversion light emitting layers 401, 402 and 403 and the µLED crystal grain 300.

In the embodiment, the insulators 102 and 202 can be disposed on the surfaces of the upper driving electrode 201 and the lower driving electrode 101 or can be disposed on the surfaces of the wavelength down-conversion light emitting layers 401, 402 and 403 or can further be disposed between the wavelength down-conversion light emitting layers 401, 402 and 403 and the upper driving electrode 201 and between the wavelength down-conversion light emitting layers 401, 402 and 403 and the lower driving electrode 101. The insulating materials 102 and 202 can be an organic insulating material, an inorganic insulating material and a combination thereof; and a thickness of the insulating materials ranges from 1 nm to 10 µm. In the embodiment, SiO2 insulating layers 202 which are 100 nm thick are preferably deposited on the surfaces of the upper driving electrode 201 and the lower driving electrode 101 by means of magnetron sputtering.

In the embodiment, the control module 600 can provide an alternating voltage with time-varying amplitude and polarity. A waveform of the alternating voltage can be, but not limited to, a sine wave, a triangular wave, a square wave, a pulse or a composite wave thereof. A frequency of the alternating voltage ranges from 1 Hz to 1000 MHz. The square wave with the alternating voltage frequency of 100MHz is preferably used in the embodiment.

In the embodiment, the optical micro-structure 500 is composed of distributed Bragg reflecting layers 501 and 503 and a patterned convex lens 502 and is located on the other surface of the substrate of the transparent electrode 201, the optical micro-structures being in one-to-one-correspondence to the unit R 11, the unit G 12 and the unit B 13, each of the distributed Bragg reflecting layers is formed by stacking two thin films with a high refractive index and a low refractive index, and blue light emitted by the µLED crystal grain 300 are transmitted partially by controlling a stacking pair number of the distributed Bragg reflecting layers 501 in the unit R 11 or the unit G 12, and a thickness of the thin films; light emitted by the µLED crystal grain 300 excites red light and green light emitted by the red wavelength down-conversion light emitting layer 401 and the green wavelength down-conversion light emitting layer 402 to transmit from the top by controlling a stacking pair number of the distributed Bragg reflecting layers 501 in the unit R 11 or the unit G 12 and a thickness of the thin films, and unabsorbed rays emitted by the µLED are reflected back to the barrier micro-structures 400 to excite the red wavelength down-conversion light emitting layer 401 and the green wavelength down-conversion light emitting layer 402 again so as to enhance the emergent intensity, so that the light emitting efficiency of the full color µLED display device without electrical contact and mass transfer is improved. The convex lens 502 is a transparent convex lens, a horizontal size of the convex lens is greater than or equal to a horizontal size of the µLED crystal grain 300 but smaller than or equal to a horizontal size of the corresponding display unit (unit R 11 or unit G 12 or unit B 13); and a longitudinal size of the convex lens 502 is greater than or equal to a longitudinal size of the µLED crystal grain 300 but smaller than or equal to a longitudinal size of the corresponding display unit (unit R 11 or unit G 12 or unit B 13).

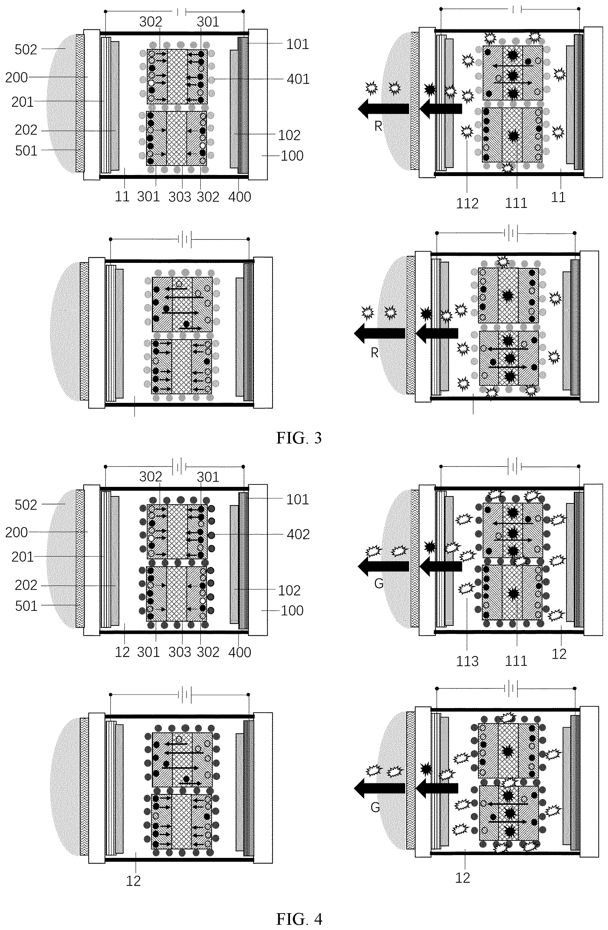

A working principle of a full-color µLED display device without electrical contact and mass transfer of an embodiment is described as follows:
Referring to FIG. 2 and FIG. 3, within a period T (including T1 and T2), at the moment T1, the upper driving electrode 201 in the unit R 11 is connected with a cathode and the lower driving electrode 101 is connected with an anode. Under an externally applied electric field action, majority carriers (holes) of the p-type semiconductor 302 in the µLED chip 300 facing or approximating the upper driving electrode 201 in an area p and majority carriers (electrons) of the n-type semiconductor 301 in the µLED chip 300 facing or approximating the upper driving electrode in an area n will drift to the light emitting structure 303 at the same time as the µLED crystal grain 300 is formed by stacking several blue light µLED chips 300 arbitrarily, and meanwhile, the blue light µLED crystal grain 310 is the pnp semiconductor junction, namely the blue light µLED chip 300, formed by stacking the p-type semiconductor material 302, the light emitting structure 303, the n-type semiconductor material 301, the light emitting structure 303 and the p-type semiconductor material 302 along the perpendicular direction. Meanwhile, as majority carriers (holes) in the n-type semiconductor 301 and minority carriers (electrons) in the p-type semiconductor 302 will drift to the light emitting structure 303 at the same time, the electrons and the holes are recombined in the light emitting structure 303 to emit the blue light 113 to excite the red quantum dot light emitting layer 401 on the surface of the µLED chip 300 to emit the red light 111 so as to realize color conversion. After the red light 111 and the blue light 113 pass through the upper insulating layer 202, the upper driving electrode 201 and the upper transparent substrate 200, the red light 111 is emitted via the distributed Bragg reflecting layer 501 and the convex lens 502, redundant blue light 113 is reflected back by the distributed Bragg reflecting layer 501 to excite the red quantum dot light emitting layer 401 on the surface of the µLED crystal grain 300 gain, and the conversion efficiency of the quantum dot light emitting layer 401 on the surface of the µLED crystal grain 300 is improved after multiple feedbacks. Meanwhile, under the externally applied electric field action, electrons and holes that are not recombined respectively drift to the p-type semiconductor layer 302 and the n-type semiconductor layer 301. At the moment T2, the lower driving electrode 101 is connected with the cathode and the upper driving electrode 201 is connected with the anode. Under the externally applied electric field action, minority carriers (electrons) in the p-type semiconductor 302 in the µLED chip 310 facing or approximately facing the upper driving electrode 201 in the area p and electrons in the light emitting structure 303 are pulled back to the n-type semiconductor 301, and minority carriers (holes) in the n-type semiconductor 301 and holes in the light emitting structure 303 are pulled back to the p-type semiconductor 302. A part of electrons and holes will emit blue light 113 after being recombined in the light emitting structure. Meanwhile, majority carriers (holes) in the p-type semiconductor 302 in the µLED chip 310 facing or approximately facing the lower driving electrode 201 in the area p drift to the light emitting structure 303, majority carriers (electrons) in the n-type semiconductor 301 drift to the light emitting structure 303, and the electrons and holes emit the blue light 113 after being recombined in the light emitting structure 303. Under the externally applied electric field action, electrons and holes that are not recombined respectively drift to the p-type semiconductor layer 302 and the n-type semiconductor layer 301. Under both circumstances, the electrons and holes are recombined to emit the blue light 113 to excite the red light 111 excited by the red quantum dot light emitting layer 401 on the surface of the µLED chip 310 to realize color conversion. After the red light 111 and the blue light 113 pass through the upper insulating layer 202, the upper driving electrode 201 and the upper transparent substrate 200, the red light 111 is emitted via the distributed Bragg reflecting layer 501 and the convex lens 502, redundant blue light 113 is reflected back by the distributed Bragg reflecting layer 501 to excite the red quantum dot light emitting layer 401 on the surface of the µLED chip 310 gain, and the conversion efficiency of the quantum dot light emitting layer 401 on the surface of crystal grain 300 is improved after multiple feedbacks. Recycling is performed in such a manner, so that the unit R 11 oscillates for many times to emit the red light 111.

Referring to FIG. 2 and FIG. 4, within a period T (including T1 and T2), at the moment T1, the upper driving electrode 201 in the unit G 12 is connected with a cathode and the lower driving electrode 101 is connected with an anode. Under an externally applied electric field action, majority carriers (holes) of the p-type semiconductor 302 in the µLED chip 300 facing or approximating the upper driving electrode 201 in an area p and minority carriers (electrons) of the n-type semiconductor 301 in the µLED chip 300 facing or approximating the upper driving electrode in an area n will drift to the light emitting structure 303 at the same time as the µLED crystal grain 300 is formed by stacking several blue light µLED chips 300 arbitrarily. Meanwhile, correspondingly, as majority carriers (holes) in the n-type semiconductor 301 and minority carriers (electrons) in the p-type semiconductor 302 will drift to the light emitting structure 303 at the same time, the electrons and the holes are recombined in the light emitting structure 303 to emit the blue light 113 to excite the green quantum dot light emitting layer 402 on the surface of the µLED chip 300 to emit the green light 112 so as to realize color conversion. After the green light 112 and the blue light 113 pass through the upper insulating layer 202, the upper driving electrode 201 and the upper transparent substrate 200, the green light 112 is emitted via the distributed Bragg reflecting layer 501 and the convex lens 502, redundant blue light 113 is reflected back by the distributed Bragg reflecting layer 501 to excite the green quantum dot light emitting layer 402 on the surface of the µLED crystal grain 300 gain, and the conversion efficiency of the quantum dot light emitting layer 402 on the surface of the µLED crystal grain 300 is improved after multiple feedbacks. Meanwhile, under the externally applied electric field action, electrons and holes that are not recombined respectively drift to the p-type semiconductor layer 302 and the n-type semiconductor layer 301. At the moment T2, the lower driving electrode 101 is connected with the cathode and the upper driving electrode 201 is connected with the anode. Under the externally applied electric field action, minority carriers (electrons) in the p-type semiconductor 302 in the µLED chip 310 facing or approximately facing the upper driving electrode 201 in the area p and electrons in the light emitting structure 303 are pulled back to the n-type semiconductor 301, and minority carriers (holes) in the n-type semiconductor 301 and holes in the light emitting structure 303 are pulled back to the p-type semiconductor 302. A part of electrons and holes will emit blue light 113 after being recombined in the light emitting structure. Meanwhile, majority carriers (holes) in the p-type semiconductor 302 in the µLED chip 310 facing or approximately facing the lower driving electrode 201 in the area p drift to the light emitting structure 303, majority carriers (electrons) in the n-type semiconductor 301 drift to the light emitting structure 303, and the electrons and holes emit the blue light 113 after being recombined in the light emitting structure 303. Under the externally applied electric field action, electrons and holes that are not recombined respectively drift to the p-type semiconductor layer 302 and the n-type semiconductor layer 301. Under both circumstances, the electrons and holes are recombined to emit the blue light 113 to excite the green light 112 excited by the green quantum dot light emitting layer 402 on the surface of the µLED chip 310 to realize color conversion. After the green light 112 and the blue light 113 pass through the upper insulating layer 202, the upper driving electrode 201 and the upper transparent substrate 200, the green light 112 is emitted via the distributed Bragg reflecting layer 501 and the convex lens 502, redundant blue light 113 is reflected back by the distributed Bragg reflecting layer 501 to excite the green quantum dot light emitting layer 402 on the surface of the µLED chip 310 gain, and the conversion efficiency of the quantum dot light emitting layer 402 on the surface of crystal grain 300 is improved after multiple feedbacks. Recycling is performed in such a manner, so that the unit G 12 oscillates for many times to emit the green light 112.

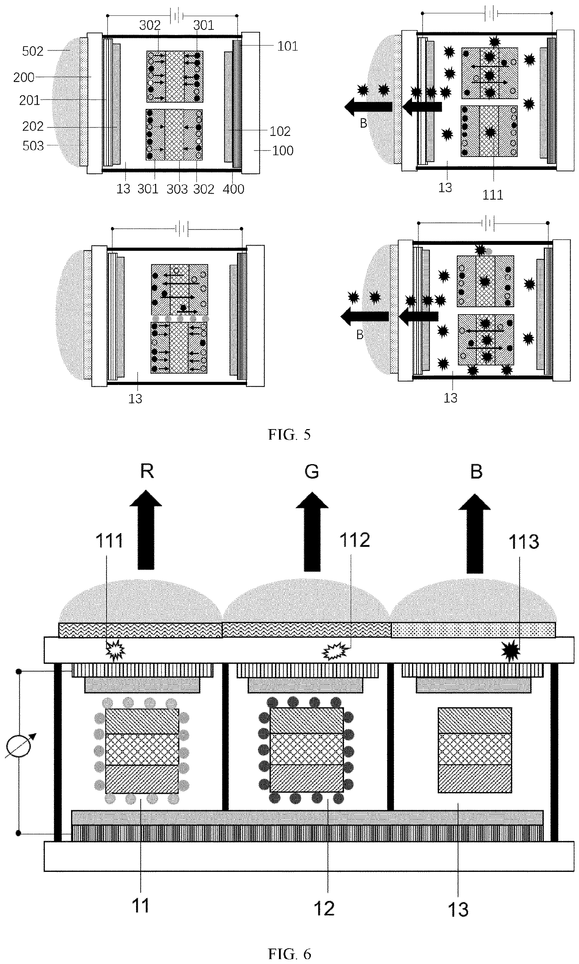

Referring to FIG. 2 and FIG. 5, within a period T (including T1 and T2), at the moment T1, the upper driving electrode 201 in the unit G 12 is connected with a cathode and the lower driving electrode 101 is connected with an anode. Under an externally applied electric field action, majority carriers (holes) of the p-type semiconductor 302 in the µLED chip 300 facing or approximating the upper driving electrode 201 in an area p and minority carriers (electrons) of the n-type semiconductor 301 in the µLED chip 300 facing or approximating the upper driving electrode in an area n will drift to the light emitting structure 303 at the same time as the µLED crystal grain 300 is formed by stacking several blue light µLED chips 300 arbitrarily. Meanwhile, correspondingly, as majority carriers (holes) in the n-type semiconductor 301 and minority carriers (electrons) in the p-type semiconductor 302 will drift to the light emitting structure 303 at the same time, the electrons and the holes are recombined in the light emitting structure 303 to emit the blue light 113. A part of blue light 113 passes through the upper insulating layer 202, the upper driving electrode 201 and the upper transparent substrate 200 and is emitted via the distributed Bragg reflecting layer 503 and the convex lens 502. Meanwhile, under the externally applied electric field action, electrons and holes that are not recombined respectively drift to the p-type semiconductor layer 302 and the n-type semiconductor layer 301. At the moment T2, the lower driving electrode 101 is connected with the cathode and the upper driving electrode 201 is connected with the anode. Under the externally applied electric field action, minority carriers (electrons) in the p-type semiconductor 302 in the µLED chip 310 facing or approximately facing the upper driving electrode 201 in the area p and electrons in the light emitting structure 303 are pulled back to the n-type semiconductor 301, and minority carriers (holes) in the n-type semiconductor 301 and holes in the light emitting structure 303 are pulled back to the p-type semiconductor 302. A part of electrons and holes will emit blue light 113 after being recombined in the light emitting structure. Meanwhile, majority carriers (holes) in the p-type semiconductor 302 in the µLED chip 310 facing or approximately facing the lower driving electrode 201 in the area p drift to the light emitting structure 303, majority carriers (electrons) in the n-type semiconductor 301 drift to the light emitting structure 303, and the electrons and holes emit the blue light 113 after being recombined in the light emitting structure 303. Under the externally applied electric field action, electrons and holes that are not recombined respectively drift to the p-type semiconductor layer 302 and the n-type semiconductor layer 301. Under both circumstances, the electrons and holes are recombined to emit the blue light 113. A part of blue light 113 passing through the upper insulating layer 202, the upper driving electrode 201 and the upper transparent substrate 200 is emitted via the distributed Bragg reflecting layer 503 and the convex lens 502. Recycling is performed in such a manner, so that the unit B 13 oscillates for many times to emit the blue light 113.

Referring to FIG. 6, within a period T, the unit R 11, the unit G 12 and the unit B 13 respectively emit the red light 111, the green light 112 and the blue light 113 so as to realize full color µLED display without electrical contact and mass transfer.

The above is the preferred embodiments of the present invention. Changes made based on the technical scheme of the present invention shall fall into the scope of protection of the present invention when generated functions are not beyond the scope of the technical scheme of the present invention.

## Claims

1. A full-color µLED display device without electrical contact and mass transfer, comprising: a lower transparent substrate, an upper lower transparent substrate, a µLED crystal grain, wavelength down-conversion light emitting layers, insulating layers, an optical micro-structure, a control module, a lower driving electrode disposed on a surface of the lower transparent substrate, an upper driving electrode disposed on a surface of the upper transparent substrate, a barrier micro-structure connecting the upper transparent substrate and the lower transparent substrate, wherein the barrier micro-structure comprises a unit R for displaying red light, a unit G for displaying green light and a unit B for displaying blue light successively formed along a direction of the upper driving electrode, wherein the barrier micro-structure in the unit R is internally provided with a red wavelength down-conversion light emitting layer and a µLED crystal grain, the barrier micro-structure in the unit G is internally provided with a green wavelength down-conversion light emitting layer and a µLED crystal grain, and the barrier micro-structure in the unit B is internally provided with a blue light µLED crystal grain or a blue wavelength down-conversion light emitting layer and a µLED crystal grain; and the upper driving electrode and the lower driving electrode are free from direct electrical contact with the µLED crystal grains; the control module is electrically connected with the upper driving electrode and the lower driving electrode respectively, provides alternating driving signals to the upper driving electrode and the lower driving electrode and forms a driving electric field between the upper driving electrode and the lower driving electrode, the driving electric field controls electron-hole recombinations of the µLED crystal grains and emits a first light that emits RGB rays via the wavelength down-conversion light emitting layers in the unit R, the unit G and the unit B so as to realize full color display via controllable scanning.

2. The full-color µLED display device without electrical contact and mass transfer according to claim 1, wherein the µLED crystal grain is either a blue light µLED crystal grain or a µLED crystal grain capable of emitting light with wavelength shorter than that of blue light; the µLED crystal grain is formed by connecting several µLED chips in series along a perpendicular direction or is formed by connecting the several µLED chips in parallel along a horizontal direction or is formed by stacking the several µLED chips arbitrarily; a horizontal size of the µLED crystal grain ranges from 1 nm to 1000 µm, a longitudinal size of the µLED crystal grain ranges from 1 nm to 1000 µm, and a thickness thereof ranges from 1 nm to 100 µm.

3. The full-color µLED display device without electrical contact and mass transfer according to claim 2, wherein the µLED chip comprises a p-type semiconductor material, a light emitting structure and an n-type semiconductor material, the p-type semiconductor material, the light emitting structure and the n-type semiconductor material being stacked along a perpendicular direction to form a semiconductor junction; the semiconductor junction comprises one of or more of a combination of a single semiconductor junction, a semiconductor junction pair and a multi-semiconductor junction; a thickness of the p-type semiconductor material ranges from 1 nm to 2.0 µm, a thickness of the light emitting structure ranges from 1 nm to 1.0 µm, and a thickness of the n-type semiconductor material ranges from 1 nm to 2.5 µm.

4. The full-color µLED display device without electrical contact and mass transfer according to claim 1, wherein the upper driving electrode is composed of several line electrodes that are parallel one another and is disposed on the surface of the upper transparent substrate along the horizontal direction of the µLED crystal grain; the lower driving electrode is composed of several line electrodes that are parallel one another and is disposed on the surface of the upper transparent substrate along the perpendicular direction of the µLED crystal grain; and the upper electrode and the lower electrode are perpendicular to each other, and an independent space can be formed in a gap between the upper electrode and the lower electrode.

5. The full-color µLED display device without electrical contact and mass transfer according to claim 1, wherein at least one of the upper driving electrode and the lower driving electrode is a transparent electrode, and a material of the transparent electrode comprises graphene, indium tin oxide, a carbon nano tube, a silver nanowire and a copper nanowire and a combination thereof; and a material of the other transparent electrode comprises gold, silver, aluminum and copper or an alloy or a laminated structure thereof.

6. The full-color µLED display device without electrical contact and mass transfer according to claim 1, wherein each of the wavelength down-conversion light emitting layers irradiated by rays emitted by the µLED crystal grain excites a ray with a longer wavelength, the wavelength down-conversion light emitting layer is a quantum dot material or a phosphor material or a mixed material of quantum dots and phosphors; the wavelength down-conversion light emitting layer comprises R/G/B quantum dots or R/G/B phosphors, the wavelength down-conversion light emitting layers are respectively disposed in the unit R, the unit G and the unit B, and a thickness of the wavelength down-conversion light emitting layer ranges from 1 nm to 10 µm; the wavelength down-conversion light emitting layers can be disposed on the surfaces of the upper driving electrode and the lower driving electrode or can be disposed on the outer surfaces of the µLED crystal grains, or can be mixed and coated together with the µLED crystal grains and are disposed in the independent space formed by the upper driving electrode and the lower driving electrode.

7. The full-color µLED display device without electrical contact and mass transfer according to claim 1, wherein each of the barrier micro-structures is perpendicularly disposed on the surface of the upper transparent substrate or is disposed on the surface of the lower transparent substrate, and forms an independent closed space with the upper driving electrode, the lower driving electrode, the wavelength down-conversion light emitting layer and the µLED crystal grain.

8. The full-color µLED display device without electrical contact and mass transfer according to claim 1, wherein the insulators can be disposed on the surfaces of the upper driving electrode and the lower driving electrode or can be disposed on the surfaces of the wavelength down-conversion light emitting layers or can be disposed between the wavelength down-conversion light emitting layer and the upper driving electrode and between the wavelength down-conversion light emitting layer and the lower driving electrode; a material of the insulators is an organic insulating material, an inorganic insulating material or a combination thereof; and a thickness of the insulating material ranges from 1 nm to 10 µm.

9. The full-color µLED display device without electrical contact and mass transfer according to claim 1, wherein the control module can provide an alternating voltage with time-varying amplitude and polarity, a waveform of the alternating voltage comprising a sine wave, a triangular wave, a square wave, a pulse or a composite wave thereof, and a frequency of the alternating voltage ranging from 1 Hz to 1000 MHz.

10. The full-color µLED display device without electrical contact and mass transfer according to claim 5, wherein the optical micro-structure is composed of a distributed Bragg reflecting layer and a convex lens and is located on the other surface of the substrate of the transparent electrode, the optical micro-structures being in one-to-one-correspondence to the unit R, the unit G and the unit B; the distributed Bragg reflecting layer is formed by stacking two thin films with a high refractive index and a low refractive index, and red light, green light and blue light in the units are transmitted respectively by controlling a stacking pair number of the distributed Bragg reflecting layers in the unit R, the unit G and the unit B and a thickness of the thin films, and unabsorbed rays emitted by the µLED are reflected back to the barrier micro-structures via the distributed Bragg reflecting layer to excite the wavelength down-conversion light emitting layers again so as to enhance the emergent intensity, so that the light emitting efficiency of the display device is improved; the convex lens is a transparent convex lens, a horizontal size of the convex lens is greater than or equal to a horizontal size of the µLED crystal grain but smaller than or equal to a horizontal size of the corresponding unit R or G or B; and a longitudinal size of the convex lens is greater than or equal to a longitudinal size of the µLED crystal grain but smaller than or equal to a longitudinal size of the corresponding unit R or G or B.
